# EUROPEAN PATENT SPECIFICATION

(11) **EP 3 883 353 B1**
(45) Date of publication and mention of the grant of the patent: **18.09.2024**
(21) Application number: 21161866.5
(22) Date of filing: 10.03.2021
(51) Int. Cl.: H05K 5/00, H05K 7/20

(54) **AUTOMOTIVE ELECTRONIC DEVICE**
ELEKTRONISCHE VORRICHTUNG FÜR KRAFTFAHRZEUGE
DISPOSITIF ÉLECTRONIQUE AUTOMOBILE

(30) Priority: 17.03.2020 TW 109108844
(43) Date of publication of application: 22.09.2021
(73) Proprietor: Askey Computer Corp., 23585 New Taipei City (TW)
(72) Inventor: CHUNG, Chao-Tsai, 23585 New Taipei City (TW); LIN, Po-Lin, 23585 New Taipei City (TW); CHAN, Shu-Ting, 23585 New Taipei City (TW)
(74) Representative: Zimmermann, Tankred Klaus

(56) References cited:
- CN-A- 106 604 620
- KR-B1- 101 887 439
- US-A- 5 590 026
- US-A- 5 923 084
- CHRISTOPHER A. SOULE ET AL: "Optimize Fin Spacing: How Close Is Too Close? | Power Electronics", 1 August 2002 (2002-08-01), XP055823007, Retrieved from the Internet <URL:https://www.powerelectronics.com/content/article/21856869/optimize-fin-spacing-how-close-is-too-close> [retrieved on 20210709]

## Description

### BACKGROUND

### Technology Field

The present disclosure relates to an automotive electronic device and, in particular, to an automotive electronic device suitable for operation under a high temperature environment.

### Description of Related Art

The operating environment of the automotive device is mostly high temperature, outdoor, or even enclosed in the vehicle. The automotive electronic device must be durable and maintain normal operation under such operating environments, and it will not be damaged while being exposed to high temperature for a long time. Since the components in the automotive electronic device still generate heat and operate under high temperature, it is needed to dissipate the heat of the components outside the casing through the heat dissipation mechanism of the automotive electronic device.

In the past, if an automotive electronic device was expected to operate in a temperature range of -30°C to 70°C, an aluminum extruded casing could meet the thermal resistance requirements under this temperature condition. However, under more severe conditions, the automotive electronic device is expected to operate in an environment below 85°C, but the components may generate heat of a higher temperature than the operating environment during operation. Under such an expected temperature environment, the heatsink of the casing of the automotive electronic device can adopt the general method to meet the thermal resistance requirements under this condition. The general method is to determine the intervals of the fins of the heatsink based on the process limit. The fins of the heatsink of the casing manufactured by die-casting process generally have intervals of about 3 mm. This method is also to arrange the fins of the heatsink as close as possible to increase the number of fins and thus increase the total fin area, but this design will cause the bad natural convection effect. US 5 590 026 A discloses a heat sink apparatus dissipates heat from an integrated circuit which is connected to a printed circuit board. KR 101 887 439 B1 discloses an electronic control apparatus including a housing, a substrate provided in the housing, and a connector connected to the substrate and partially exposed to one side of the housing.

However, the above methods cannot satisfy the severe thermal resistance requirement and the expected operation environment for the automotive electronic device at the temperature of 95°C.

### SUMMARY

In view of the foregoing, this disclosure is to provide an automotive electronic device suitable for operation under a high temperature environment.

In one embodiment, an automotive electronic device durable in an automotive environment of at least 95°C comprises a bottom cover, a circuit board and a heatsink casing. The circuit board is installed on the bottom cover. The heatsink casing is assembled with the bottom cover and covers the circuit board between the heatsink casing and the bottom cover. The heatsink casing comprises an outer surface, a plurality of long fins and a plurality of side fins. The long fins are arranged on the outer surface along a first direction, and two adjacent long fins have a distance at least greater than 8 mm. The side fins are arranged on an edge of the outer surface along a second direction and connected to one of the long fins. The first direction is perpendicular to the second direction. Main axes of the long fins are disposed along the second direction. Main axes of the side fins are disposed along the first direction. The heatsink casing and the bottom cover are assembled to form a closed space for accommodating the circuit board so as to provide dustproof and waterproof to the circuit board. The outer surface comprises a plurality of regions with different heights, the regions are individually disposed between two adjacent ones of the long fins so as to form grooves with different depths for providing different heat convection effects. The side fins are perpendicular to the long fins and the outer surface. The bottom cover further comprises a protruding platform and a heat conductive element, the protruding platform is disposed right underneath a communication module or a processor of the circuit board. A gap is configured between the circuit board and the protruding platform, the heat conductive element is filled in the gap. The heatsink casing is an aluminum die-casting casing, and the bottom cover is an aluminum stamping casing or an aluminum die-casting casing. The automotive electronic device comprises a battery, the heatsink casing comprises a battery cover, the battery and the side fins are disposed at two opposite sides of the automotive electronic device, the battery cover comprises a recess portion, and the recess portion covers above the battery and contacts the battery through a heat conductive element for dissipating a heat of the battery. The automotive electronic device comprises a plurality of terminal joints individually disposed at sides of the heatsink casing, the heatsink casing comprises a plurality of joint covers disposed over the terminal joints, a part of each of the terminal joints is disposed inside corresponding one of the joint covers, the other part of each of the terminal joints is protruded from the corresponding one of the joint covers, the joint covers are substantially the same height as the long fins, and in a view from a top of the heatsink casing, two of the long fins and the joint covers surround four sides of a groove to enclose the groove.

In one embodiment, a lower part of the outer surface is formed with a concave portion, the concave portion has a thicker casing thickness, and the concave portion is located right above a communication module or a processor of the circuit board.

In one embodiment, the electronic device further comprises a component unit and a heat conductive element. The component unit is disposed on the circuit board, and a gap between the component unit and the heatsink casing is less than 0.5 mm. The heat conductive element is filled in the gap, and a thickness of the heat conductive element in the gap is less than 0.5 mm.

In one embodiment, the gap between the circuit board and the protruding platform is less than 2 mm, and a thickness of the heat conductive element in the gap is less than 0.2 mm.

In one embodiment, the heat conductive element is a heat conductive paste, a heat conductive pad, or a heat conductive putty.

In one embodiment, the electronic device further comprises a heat conductive medium disposed on the circuit board and contacting the heatsink casing or the bottom cover.

As mentioned above, in the automotive electronic device of this disclosure, the distance between two adjacent long fins is at least greater than 8 mm, which is obviously larger than the intervals (3 mm) of the fins of the conventional heatsink manufactured based on the process limit and the close arrangement rule. Since the distance of this disclosure is wide enough, more air can be carried to flow downwardly to supplement the original space of the hot air after the hot air rises between the fins. Compared with the conventional design (the interval of 3 mm between the fins), this disclosure can provide a better convection effect and increase the airflow circulation under the condition of maintaining or sacrificing some fins within the same surface area. Accordingly, the automotive electronic device of this disclosure is durable in the automotive environment of at least 95°C.

In addition, compared with the design of disposing the long fins parallel to the long sides, the long fins and the short sides of the heatsink casing are in parallel along the second direction, so that the length of the fins can be reduced so as to decrease the flowing distance of air after entering the interval between the fins. This configuration can decrease the flowing resistance and the pressure loss, and increase the heat exchange coefficient. Moreover, the side fins are perpendicular to the long fins, and the surfaces of the side fins are parallel to the gravity direction. Thus, the heat convection generated by the hot air buoyancy can be effectively utilized. Furthermore, the gap between the component unit and the heatsink casing is less than 0.5 mm, the heat conductive element is filled in the gap, and the thickness of the heat conductive element in the gap is less than 0.5 mm. This configuration can sufficiently decrease the heat transfer resistance. Accordingly, the automotive electronic device of this disclosure can be durable in the automotive environment of at least 95°C, and the additional fan is unnecessary. In this disclosure, only the natural convection is enough for dissipating the heat, thereby maintaining the stable operation of the electronic components inside the device.

### BRIEF DESCRIPTION OF THE DRAWINGS

The disclosure will become more fully understood from the detailed description and accompanying drawings, which are given for illustration only, and thus are not limitative of the present disclosure, and wherein:
FIG. 1 is an exploded view of an automotive electronic device according to an embodiment;
FIG. 2 is a perspective view of the heatsink casing of FIG. 1;
FIG. 3A is a sectional view of the automotive electronic device according to the embodiment;
FIGS. 3B and 3C are sectional views of the automotive electronic device according to the embodiment;
FIGS. 4 and 5 are schematic diagrams showing the airflow field of the automotive electronic device according to the embodiment; and
FIG. 6 is a schematic diagram showing the airflow field of the side heat convection of the automotive electronic device according to the embodiment.

### DETAILED DESCRIPTION OF THE DISCLOSURE

The present disclosure will be apparent from the following detailed description, which proceeds with reference to the accompanying drawings, wherein the same references relate to the same elements.

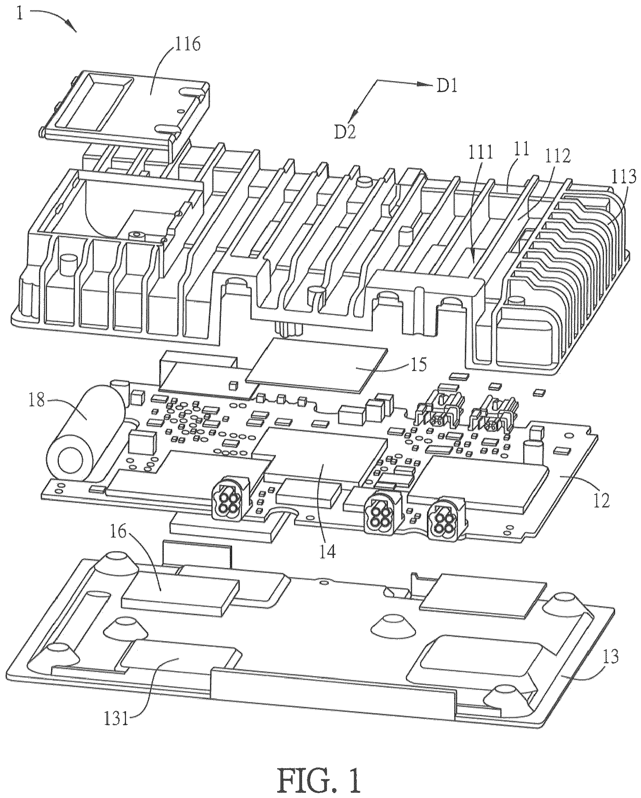

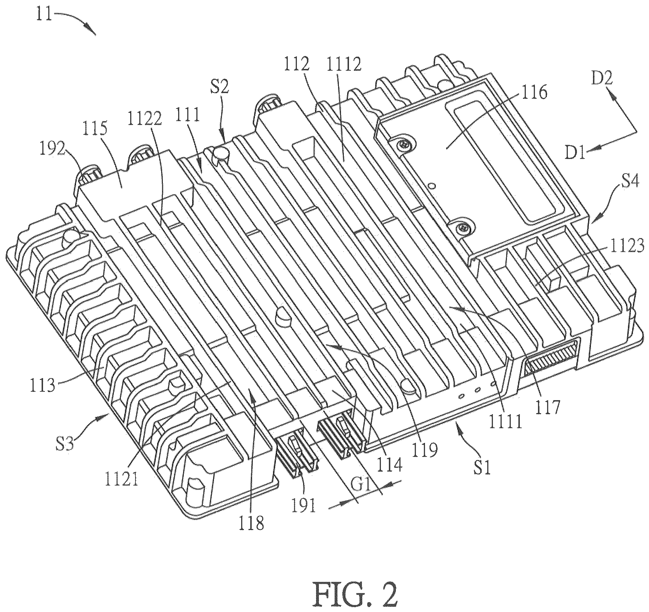

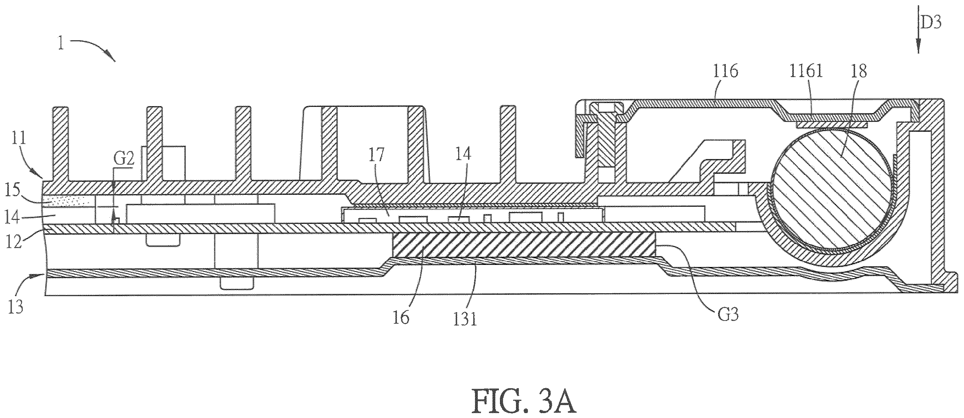

FIG. 1 is an exploded view of an automotive electronic device according to an embodiment, FIG. 2 is a perspective view of the heatsink casing of FIG. 1, and FIG. 3A is a sectional view of the automotive electronic device according to the embodiment. Referring to FIGS. 1, 2 and 3A, the automotive electronic device 1 includes: a heatsink casing 11, a circuit board 12, and a bottom cover 13. The heatsink casing 11 is an aluminum die-casting casing, and the bottom cover 13 is an aluminum stamping casing or an aluminum die-casting casing. The automotive electronic device 1 can be, for example, a communication device, a computing device, or the like. The automotive electronic device 1 can be installed at a proper place inside the vehicle such as the place under the car seat, in the trunk, under the driving dashboard, or the likes.

The circuit board 12 is installed on the bottom cover 13. For example, the circuit board 12 can be a printed circuit board, a flexible circuit board, or the like. The circuit board 12 can be configured with one or more component units 14 such as the battery, active element, passive element and the likes (e.g. chips, antennas, resistors, capacitors, inductors, or the likes). The heat of the circuit board 12 and the component units can be dissipated to outside through the heatsink casing 11 and/or the bottom cover 13. Regarding an automotive chip, the upper limit of the tolerable operating temperature is about 115°C. In the general vehicle conditions, the temperature of the chip will be about 10°C higher than the environment. If the vehicle temperature reaches 95°C, the temperature of the chip will be at least 95°C or more, or even at least 105°C or more, and the temperature of the heatsink casing 11 will be at least 95°C or more.

The heatsink casing 11 is assembled with the bottom cover 13 and covers the circuit board 12 between the heatsink casing 11 and the bottom cover 13. The heatsink casing 11 and the bottom cover 13 can be assembled to form a closed space for accommodating the circuit board 12. This configuration can provide the protections (e.g. dustproof and waterproof) to the components inside the automotive electronic device such as the circuit board 12 or the component units.

As viewing from the top of the figures, the shapes of the heatsink casing 11 and the circuit board 12 are rectangles. The long sides of the heatsink casing 11 and the circuit board 12 are arranged along a first direction D1, and the short sides of the heatsink casing 11 and the circuit board 12 are arranged along a second direction D2. The first direction D1 can be perpendicular to the second direction D2. In addition, in other embodiments, the heatsink casing 11 may have a different shape, and the shape of the heatsink casing 11 depends on the shape of the circuit board 12.

The heatsink casing 11 comprises an outer surface 111, a plurality of long fins 112, and a plurality of side fins 113. The long fins 112 are arranged on the outer surface 111 along the first direction D1, and two adjacent ones of the long fins 112 have a distance G1, which is at least greater than 8 mm. The main axis of each long fin 112 is arranged along the second direction D2 and is parallel to the short sides of the heatsink casing 11. The long fins 112 can be perpendicular to the outer surface 111.

The side fins 113 are arranged on an edge of the outer surface 111 along the second direction D2 and connected to one of the long fins 112. The main axis of each side fin 113 is disposed along the first direction D1. The side fins 113 can be perpendicular to the outer surface 111. In addition, the side fins 113 are parallel to a gravity direction D3. That is, the normal direction of the outer surface 111 can be parallel to the gravity direction D3.

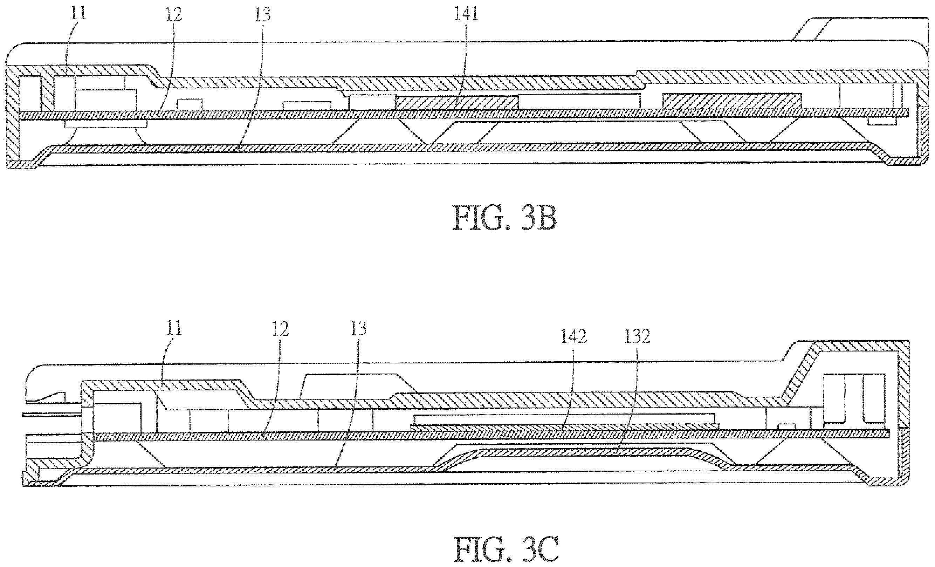

The outer surface 111 comprises a plurality of regions 1111 and 1112 with different heights. The region 1112 is lower than the region 1111 so as to form a concave portion, which can allow the heatsink casing 11 to be closer to the heat source. The regions 1111 and 1112 are individually disposed between two adjacent ones of the long fins 112 so as to form a groove 117 with different depths or multiple grooves individually having different depths for providing different heat convection effects. The outer surface 111 and the long fins 112 with different heights can also form the grooves with different depths for providing different heat convection effects. The grooves 117 with different depths can be formed by configuring the regions 1111 and 1112 with different heights and/or the long fins 112 with different heights. The regions with different depths can be applied to the heat sources with different heat levels or different structural shapes. For example, as shown in FIG. 3B, the part of the outer surface 111, which is right underneath the processor 141 of the circuit board 12, has a lower portion so as to form a concave portion. The concave portion has a thicker casing thickness, so that the heat of the processor 141 can be dissipated through the right-above groove. Of course, the processor 141 can be replaced by any of other electronic components (e.g. a communication module 142).

Referring to FIGS. 1, 2 and 3A, the automotive electronic device 1 comprises a plurality of terminal joints 191 and 192, and the heatsink casing 11 comprises a plurality of joint covers 114 and 115, which are disposed over the terminal joints 191 and 192. A part of each of the terminal joints 191 and 192 is disposed inside the joint cover 114 or 115, and the other part thereof is protruded from the corresponding joint cover 114 or 115. The terminal joint 191 and the joint cover 114 are disposed at one side S1 of the heatsink casing 11, and the terminal joint 192 and the joint cover 115 are disposed at the other side S2 of the heatsink casing 11. The joint covers 114 and 115 are not higher than the long fins 112. In one aspect, the joint covers 114 and 115 substantially have the same height as the long fins 112. In the view from a top of the heatsink casing 11, two long fins 1121, 1122 and the joint covers 114, 115 surround four sides of a groove 118 to enclose the groove 118, so that the air is forbidden to flow directly into the groove 118 through the four sides of the groove 118. The increased width of the groove 118 is configured to help a relatively cold air above the groove 118 to enter the groove 118 to induce a heat convection. One side of the groove 119 is not surrounded, and the residual three sides of the groove 119 are surrounded by two long fins 112 and one joint cover 114. This configuration can improve the problem that the air cannot flow into the groove 119 easily. The increased width of the groove 119 is configured to help a relatively cold air above the groove 119 to enter the groove 119 to induce a heat convection. In general, the wire length on the circuit board between the processor chip and the terminal joint is as short as possible. Accordingly, the processor chip is disposed around the terminal joint. This design can overcome the poor heat dissipating issue caused by the middle parts of the terminal joints 191 and 192 and the joint covers 114 and 115, which may interfere the heat convection.

In addition, the automotive electronic device 1 further comprises a battery 18. The battery 18 and the side fins 113 are disposed at two opposite sides S3 and S4 of the automotive electronic device 1, respectively. The battery 18 is disposed at the side S4 for preventing the influence of heat dissipation. The heatsink casing 11 comprises a battery cover 116, which covers the battery 18. The battery cover 116 comprises a recess portion 1161, and the recess portion 1161 covers above the battery 18 and contacts the battery 18 through a heat conductive element for dissipating a heat of the battery 18. The long fins 112 may have different lengths. For example, the long fin 1123 located next to the battery cover 116 is shorter.

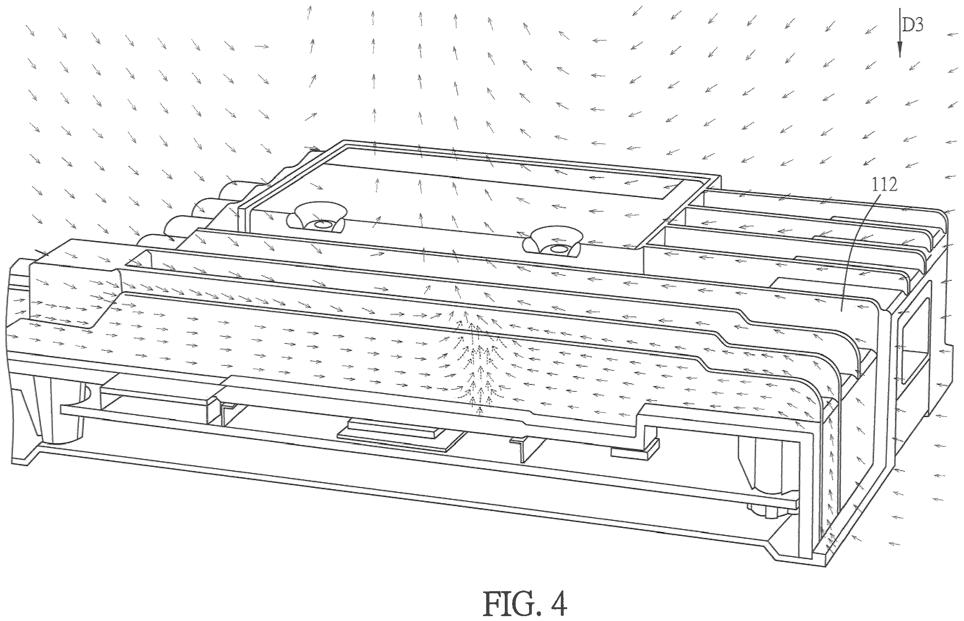

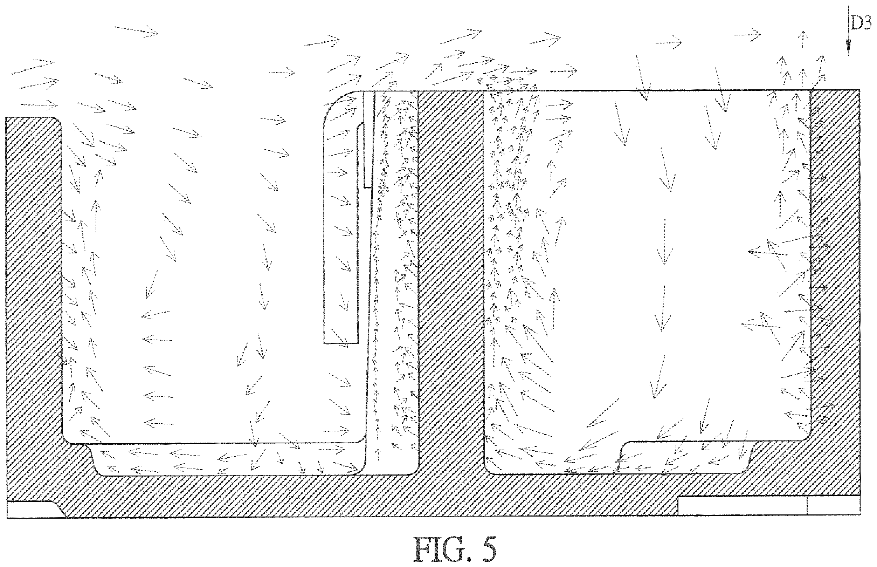

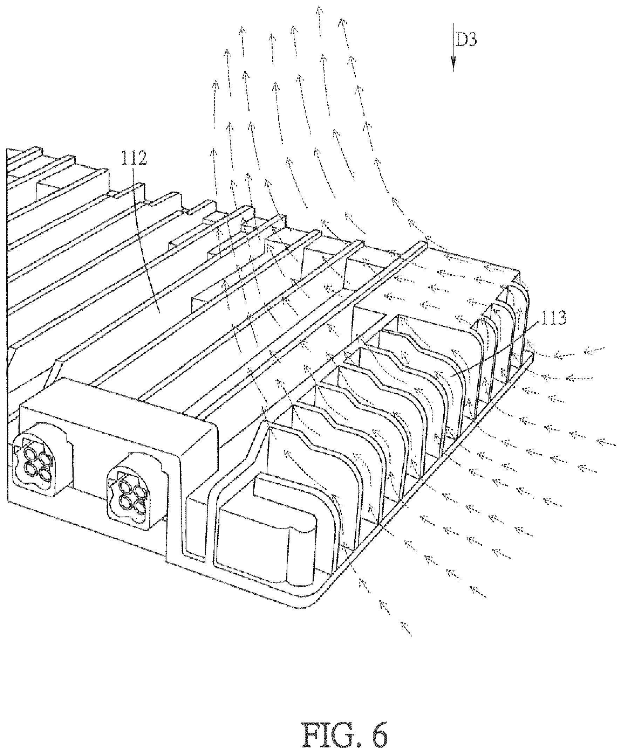

FIGS. 4 and 5 are schematic diagrams showing the airflow field of the automotive electronic device according to the embodiment, and FIG. 6 is a schematic diagram showing the airflow field of the side heat convection of the automotive electronic device according to the embodiment.

As shown in FIGS. 4 and 5, in the automotive electronic device 1, the distance G1 between two adjacent long fins 112 is greater than 8 mm, which is obviously larger than the intervals (3 mm) of the fins of the conventional heatsink manufactured based on the process limit and the close arrangement rule. Since the distance of this disclosure is wide enough, more air can be carried to flow downwardly to supplement the original space of the hot air after the hot air rises between the long fins 112, thereby enhancing the heat convection efficiency. Compared with the conventional design (the interval of 3 mm between the fins), this disclosure can provide a better convection effect and increase the airflow circulation under the condition of maintaining or sacrificing some fins within the same surface area.

In addition, compared with the design of disposing the long fins parallel to the long sides, the long fins 112 and the short sides of the heatsink casing 11 are in parallel along the second direction D2, so that the length of the fins can be reduced so as to decrease the flowing distance of air after entering the interval between the long fins 112. This configuration can decrease the flowing resistance and the pressure loss, and increase the heat exchange coefficient so as to increase the heat dissipating effect.

Regarding the groove 118 (four sides of the groove 118 are blocked), in the case adopting the conventional design (3 mm), no external air can enter the groove 118 through the four sides of the groove 118, and only the natural convection is applied to dissipating heat under the environment of over 95°C. Thus, the amount of the relatively cold air located above the long fins 112 flowing downwardly into the groove 118 is limited, so that the air convection is poor and the heat is almost not dissipated. In the design of this disclosure, the above problem can be effectively solved, thereby improving the heat convection and enhancing the heat convection efficiency. Accordingly, this disclosure is suitable for the operation environment of at least 95°C. Of course, this disclosure also works in the case of the groove 119, wherein three sides of the groove 119 are blocked.

As shown in FIG. 6, the side fins 113 can be perpendicular to the long fins 112, and the surfaces of the side fins 113 are parallel to the gravity direction. This configuration can utilize the hot air buoyancy to induce the heat convection on the outer surface 111. Combined with the design of wider intervals between the long fins 112, the total airflow amount of the natural convection can be efficiently increased, thereby effectively utilizing the heat convection generated by the hot air buoyancy.

Referring to FIGS. 1 and 3A, the electronic device 1 further comprises a component unit 14 and a heat conductive element 15. The component unit 14 is disposed on the circuit board 12, and a gap G2 between the component unit 14 and the heatsink casing 11 is less than 0.5 mm. The heat conductive element 15 is filled in the gap G2, and a thickness of the heat conductive element 15 in the gap G2 is less than 0.5 mm. The heat conductive element 15 can be a heat conductive paste, a heat conductive pad, or a heat conductive putty. For example, the heat conductive paste is a heat conductive AB glue. For example, the component unit 14 is an active element, a passive element, or the like, such as a chip, an antenna, a resistor, a capacitor, or an inductor.

The bottom cover 13 further comprises a protruding platform 131, which protrudes from the bottom cover 13 towards the heatsink casing 11. A gap G3 between the circuit board 12 and the protruding platform 131 is less than 2 mm, a heat conductive element 16 is filled in the gap G3, and a thickness of the heat conductive element 16 in the gap G3 is less than 0.2 mm. The heat conductive element 16 can be a heat conductive paste, a heat conductive pad, or a heat conductive putty. For example, the heat conductive paste is a heat conductive AB glue. As shown in FIG. 3C, the protruding platform 132 is disposed right underneath the communication module 142 of the circuit board 12 and is located adjacent to the lower surface of the circuit board 12. This configuration is benefit for dissipating the heat of the communication module 142 through the protruding platform 132. Of course, the communication module can be replaced by any of other heat sources, such as a processor. In addition, a heat conductive element can be provided between the protruding platform 132 and the circuit board 12.

In addition, if the heat dissipation requirement of the heat source gets higher, it is possible to form the concave portion of the casing above the heat source and the protruding platform of the bottom cover 13 below the heat source, so that the heat of the heat source can be dissipated through the upper side and the lower side.

The electronic device may further comprise a heat conductive medium 17. The heat conductive medium 17 can be disposed on the upper surface of the circuit board 12 and contact the heatsink casing 11. Alternatively, the heat conductive medium 17 can be disposed on the lower surface of the circuit board 12 and contact the bottom cover 13. For example, the heat conductive medium 17 is a heat conductive AB glue. The thickness of the heat conductive medium 17 can be less than 0.5 mm or, preferably, less than 0.2 mm. The heat conductive medium 17 may encapsulate some components.

The gap between the component (unit) and the heatsink casing can be filled by the heat conductive element or medium for decreasing the thermal resistance. The thermal resistance of thermal conduction is directly proportional to the thickness of the heat conductive medium and inversely proportional to the thermal conductivity coefficient. Therefore, reducing the thickness of the heat conductive medium to less than 0.5 mm can greatly reduce the thermal resistance of thermal conduction. The gap G2 between the component unit 14 and the heatsink casing 11 is less than 0.5 mm. Therefore, the thickness of the heat conductive element 15 in the gap G2 is less than 0.5 mm, which can greatly reduce the thermal resistance of thermal conduction. Similarly, the thickness of the heat conductive element 16 in the gap G3 is less than 0.2 mm, and the thickness of the heat conductive medium 17 can be less than 0.5 mm, or even less than 0.2 mm, which can greatly reduce the thermal resistance of thermal conduction.

In the past, the heat conductive medium also provides the function of absorbing assembly tolerances, so a thicker heat conductive medium with the compressible property is used. In order to cover the range of possible gaps, and to reduce the reaction force after compression to avoid excessive deformation of the circuit board, the thickness of the thermal conductive medium is usually more than 2 mm. However, if the thickness of the heat conductive medium is increased and the thermal resistance is to be reduced, a heat conductive medium with a high thermal conductivity coefficient must be used. However, the heat conductive medium with a high thermal conductivity coefficient may lead to the increase of hardness and decrease of compression. Therefore, the heat conductive medium must be thicker, which leads to a vicious cycle of design. In contrast, the automotive electronic device of this disclosure can avoid the above-mentioned vicious cycle.

In summary, in the automotive electronic device of this disclosure, the distance between two adjacent long fins is at least greater than 8 mm, which is obviously larger than the intervals (3 mm) of the fins of the conventional heatsink manufactured based on the process limit and the close arrangement rule. Since the distance of this disclosure is wide enough, more air can be carried to flow downwardly to supplement the original space of the hot air after the hot air rises between the fins. Compared with the conventional design (the interval of 3 mm between the fins), this disclosure can provide a better convection effect and increase the airflow circulation under the condition of maintaining or sacrificing some fins within the same surface area. Accordingly, the automotive electronic device of this disclosure is durable in the automotive environment of at least 95°C.

In addition, compared with the design of disposing the long fins parallel to the long sides, the long fins and the short sides of the heatsink casing are in parallel along the second direction, so that the length of the fins can be reduced so as to decrease the flowing distance of air after entering the interval between the fins. This configuration can decrease the flowing resistance and the pressure loss, and increase the heat exchange coefficient. Moreover, the side fins are perpendicular to the long fins, and the surfaces of the side fins are parallel to the gravity direction. Thus, the heat convection generated by the hot air buoyancy can be effectively utilized. Furthermore, the gap between the component unit and the heatsink casing is less than 0.5 mm, the heat conductive element is filled in the gap, and the thickness of the heat conductive element in the gap is less than 0.5 mm. This configuration can sufficiently decrease the heat transfer resistance. Accordingly, the automotive electronic device of this disclosure can be durable in the automotive environment of at least 95°C, and the additional fan is unnecessary. In this disclosure, only the natural convection is enough for dissipating the heat, thereby maintaining the stable operation of the electronic components inside the device.

Although the disclosure has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the disclosure, the scope of the invention being defined by the appended claims.

## Claims

1. An automotive electronic device (1) durable in an automotive environment of at least 95°C, comprising:
a bottom cover (13);
a circuit board (12) installed on the bottom cover; and
a heatsink casing (11) assembled with the bottom cover and covering the circuit board between the heatsink casing and the bottom cover, wherein the heatsink casing comprises:
an outer surface (111),
a plurality of long fins (112) arranged on the outer surface along a first direction,
wherein two adjacent long fins have a distance at least greater than 8 mm, and
a plurality of side fins (113) arranged on an edge of the outer surface along a second direction and connected to one of the long fins, wherein the first direction is perpendicular to the second direction, main axes of the long fins are disposed along the second direction, main axes of the side fins are disposed along the first direction, and the heatsink casing and the bottom cover are assembled to form a closed space for accommodating the circuit board so as to provide dustproof and waterproof to the circuit board, wherein the outer surface comprises a plurality of regions (1111, 1112) with different heights, the regions are individually disposed between two adjacent ones of the long fins so as to form grooves (117) with different depths for providing different heat convection effects, wherein the side fins are perpendicular to the long fins and the outer surface, wherein the bottom cover further comprises a protruding platform (131, 132) and a heat conductive element (16), the protruding platform is disposed right underneath a communication module (142) or a processor (141) of the circuit board, a gap (G3) is configured between the circuit board and the protruding platform, the heat conductive element is filled in the gap;
wherein the heatsink casing is an aluminum die-casting casing, and the bottom cover is an aluminum stamping casing or an aluminum die-casting casing;
wherein the automotive electronic device comprises a battery (18), the heatsink casing comprises a battery cover (116), the battery and the side fins are disposed at two opposite sides of the automotive electronic device, the battery cover comprises a recess portion (1161), and the recess portion covers above the battery and contacts the battery through a heat conductive element for dissipating a heat of the battery; and
wherein the automotive electronic device comprises a plurality of terminal joints (191, 192) individually disposed at sides of the heatsink casing, the heatsink casing comprises a plurality of joint covers (114, 115) disposed over the terminal joints, a part of each of the terminal joints is disposed inside corresponding one of the joint covers, the other part of each of the terminal joints is protruded from the corresponding one of the j oint covers, the j oint covers are substantially the same height as the long fins, and in a view from a top of the heatsink casing, two of the long fins and the joint covers surround four sides of a groove to enclose the groove.

2. The electronic device of claim 1, wherein a lower part of the outer surface is formed with a concave portion, the concave portion has a thicker casing thickness, and the concave portion is located right above a communication module or a processor of the circuit board.

3. The electronic device of claim 1, further comprising:
a component unit (14) disposed on the circuit board, wherein a gap (G2) between the component unit and the heatsink casing is less than 0.5 mm; and
a heat conductive element (15) filled in the gap, wherein a thickness of the heat conductive element in the gap is less than 0.5 mm.

4. The electronic device of claim 1, wherein the
gap between the circuit board and the protruding platform is less than 2 mm, and a thickness of the heat conductive element in the gap is less than 0.2 mm.

5. The electronic device of claim 3 or 4, wherein the heat conductive element is a heat conductive paste, a heat conductive pad, or a heat conductive putty.

6. The electronic device of claim 1, further comprising:
a heat conductive medium (17) disposed on the circuit board and contacting the heatsink casing or the bottom cover.

## Patentansprüche

1. Eine elektronische Kraftfahrzeugvorrichtung (1), die in einer Kraftfahrzeugumgebung von mindestens 95 °C haltbar ist, wobei dieselbe folgende Merkmale aufweist:
eine Bodenabdeckung (13);
eine Schaltungsplatine (12), die auf der Bodenabdeckung installiert ist; und
ein Wärmesenkengehäuse (11), das mit der Bodenabdeckung zusammengebaut ist und die Schaltungsplatine zwischen dem Wärmesenkengehäuse und der Bodenabdeckung abdeckt, wobei das Wärmesenkengehäuse folgende Merkmale aufweist:
eine äußere Oberfläche (111),
eine Mehrzahl von langen Rippen (112), die auf der äußeren Oberfläche entlang einer ersten Richtung angeordnet sind, wobei zwei benachbarte lange Rippen einen Abstand von mindestens mehr als 8 mm aufweisen, und
eine Mehrzahl von Seitenrippen (113), die auf einer Kante der äußeren Oberfläche entlang einer zweiten Richtung angeordnet sind und mit einer der langen Rippen verbunden sind, wobei die erste Richtung senkrecht zu der zweiten Richtung ist, wobei Hauptachsen der langen Rippen entlang der zweiten Richtung angeordnet sind, wobei Hauptachsen der Seitenrippen entlang der ersten Richtung angeordnet sind, und wobei das Wärmesenkengehäuse und die Bodenabdeckung zusammengebaut sind, um einen geschlossenen Raum zum Aufnehmen der Schaltungsplatine zu bilden, um der Schaltungsplatine Staub- und Wasserdichtigkeit bereitzustellen, wobei die äußere Oberfläche eine Mehrzahl von Bereichen (1111, 1112) mit unterschiedlichen Höhen aufweist, wobei die Bereiche einzeln zwischen zwei benachbarten der langen Rippen angeordnet sind, um Rillen (117) mit unterschiedlichen Tiefen zum Bereitstellen unterschiedlicher Wärmekonvektionseffekte zu bilden, wobei die Seitenrippen senkrecht zu den langen Rippen und der äußeren Oberfläche sind, wobei die Bodenabdeckung ferner eine vorstehende Plattform (131, 132) und ein wärmeleitendes Element (16) aufweist, wobei die vorstehende Plattform direkt unter einem Kommunikationsmodul (142) oder einem Prozessor (141) der Schaltungsplatine angeordnet ist, wobei ein Spalt (G3) zwischen der Schaltungsplatine und der vorstehenden Plattform konfiguriert ist, wobei das wärmeleitende Element in den Spalt gefüllt ist;
wobei das Wärmesenkengehäuse ein Aluminiumdruckgussgehäuse ist und die Bodenabdeckung ein Aluminiumstanzgehäuse oder ein Aluminiumdruckgussgehäuse ist;
wobei die elektronische Kraftfahrzeugvorrichtung eine Batterie (18) aufweist, wobei das Wärmesenkengehäuse eine Batterieabdeckung (116) aufweist, wobei die Batterie und die Seitenrippen an zwei gegenüberliegenden Seiten der elektronischen Kraftfahrzeugvorrichtung angeordnet sind, wobei die Batterieabdeckung einen Aussparungsabschnitt (1161) aufweist und wobei der Aussparungsabschnitt über der Batterie abdeckt und die Batterie durch ein wärmeleitendes Element zum Ableiten einer Wärme der Batterie kontaktiert; und
wobei die elektronische Kraftfahrzeugvorrichtung eine Mehrzahl von Anschlussverbindungen (191, 192) aufweist, die einzeln an Seiten des Wärmesenkengehäuses angeordnet sind, wobei das Wärmesenkengehäuse eine Mehrzahl von Verbindungsabdeckungen (114, 115) aufweist, die über den Anschlussverbindungen angeordnet sind, wobei ein Teil jeder der Anschlussverbindungen innerhalb einer entsprechenden der Verbindungsabdeckungen angeordnet ist, wobei der andere Teil jeder der Anschlussverbindungen von der entsprechenden der Verbindungsabdeckungen vorsteht, wobei die Verbindungsabdeckungen im Wesentlichen die gleiche Höhe wie die langen Rippen aufweisen, und wobei in einer Ansicht von einer Oberseite des Wärmesenkengehäuses zwei der langen Rippen und die Verbindungsabdeckungen vier Seiten einer Rille umgeben, um die Rille zu umschließen.

2. Die elektronische Vorrichtung gemäß Anspruch 1, wobei ein unterer Teil der äußeren Oberfläche mit einem konkaven Abschnitt ausgebildet ist, wobei der konkave Abschnitt eine dickere Gehäusedicke aufweist und wobei der konkave Abschnitt direkt über einem Kommunikationsmodul oder einem Prozessor der Schaltungsplatine angeordnet ist.

3. Die elektronische Vorrichtung gemäß Anspruch 1, die ferner folgende Merkmale aufweist:
eine Komponenteneinheit (14), die auf der Schaltungsplatine angeordnet ist, wobei ein Spalt (G2) zwischen der Komponenteneinheit und dem Wärmesenkengehäuse weniger als 0,5 mm beträgt; und
ein wärmeleitendes Element (15), das in den Spalt gefüllt ist, wobei eine Dicke des wärmeleitenden Elements in dem Spalt weniger als 0,5 mm beträgt.

4. Die elektronische Vorrichtung gemäß Anspruch 1, wobei
ein Spalt zwischen der Schaltungsplatine und der vorstehenden Plattform weniger als 2 mm beträgt und eine Dicke des wärmeleitenden Elements in dem Spalt weniger als 0,2 mm beträgt.

5. Die elektronische Vorrichtung gemäß Anspruch 3 oder 4, wobei das wärmeleitende Element eine wärmeleitende Paste, eine wärmeleitende Kontaktfläche oder ein wärmeleitender Kitt ist.

6. Die elektronische Vorrichtung gemäß Anspruch 1, die ferner folgendes Merkmal aufweist:
ein wärmeleitendes Medium (17), das auf der Schaltungsplatine angeordnet ist und das Wärmesenkengehäuse oder die Bodenabdeckung kontaktiert.

## Revendications

1. Dispositif électronique pour automobile (1) résistant dans un environnement automobile d'au moins 95°C, comprenant:
un couvercle de fond (13);
une carte de circuit imprimé (12) installée sur le couvercle de fond; et
un boîtier de dissipateur de chaleur (11) assemblé avec le couvercle de fond et recouvrant la carte de circuit imprimé entre le boîtier de dissipateur de chaleur et le couvercle de fond, où le boîtier de dissipateur de chaleur comprend:
une surface extérieure (111),
une pluralité d'ailettes longues (112) disposées sur la surface extérieure le long d'une première direction,
dans lequel deux ailettes longues adjacentes présentent une distance au moins supérieure à 8 mm, et
une pluralité d'ailettes latérales (113) disposées sur un bord de la surface extérieure le long d'une deuxième direction et connectées à l'une des ailettes longues, où la première direction est perpendiculaire à la deuxième direction, les axes principaux des ailettes longues sont disposés le long de la deuxième direction, les axes principaux des ailettes latérales sont disposés le long de la première direction, et le boîtier de dissipateur de chaleur et le couvercle de fond sont assemblés pour former un espace fermé destiné à recevoir la carte de circuit imprimé de manière à créer une étanchéité à la poussière et à l'eau de la carte de circuit imprimé, où la surface extérieure comprend une pluralité de régions (1111, 1112) de hauteurs différentes, les régions sont disposées individuellement entre deux adjacentes des ailettes longues de manière à former des rainures (117) de profondeurs différentes pour créer différents effets de convection de chaleur, où les ailettes latérales sont perpendiculaires aux ailettes longues et à la surface extérieure, où le couvercle de fond comprend par ailleurs un plate-forme en saillie (131, 132) et un élément conducteur de chaleur (16), la plate-forme en saillie est disposée immédiatement au-dessous d'un module de communication (142) ou d'un processeur (141) de la carte de circuit imprimé, un espace (G3) est configuré entre la carte de circuit imprimé et la plate-forme en saillie, l'élément conducteur de chaleur est rempli dans l'espace;
dans lequel le boîtier de dissipateur de chaleur est un boîtier en aluminium moulé sous pression, et le couvercle de fond est un boîtier en aluminium estampé ou un boîtier en aluminium moulé sous pression;
dans lequel le dispositif électronique pour automobile comprend une batterie (18), le boîtier de dissipateur de chaleur comprend un couvercle de batterie (116), la batterie et les ailettes latérales sont disposées de deux côtés opposés du dispositif électronique pour automobile, le couvercle de batterie comprend une partie en retrait (1161), et la partie en retrait recouvre la batterie et entre en contact avec la batterie par l'intermédiaire d'un élément conducteur de chaleur destiné à dissiper la chaleur de la batterie; et
dans lequel le dispositif électronique pour automobile comprend une pluralité de joints de borne (191, 192) disposés individuellement sur des côtés du boîtier de dissipateur de chaleur, le boîtier de dissipateur de chaleur comprend une pluralité de couvre-joints (114, 115) disposés au-dessus des joints de borne, une partie de chacun des joints de borne est disposée à l'intérieur de l'un correspondant des couvre-joints, l'autre partie de chacun des joints de borne ressort de l'un correspondant des couvre-joints, les couvre-joints ont sensiblement de la même hauteur que les ailettes longues, et en vue depuis le haut du boîtier de dissipateur de chaleur, deux des ailettes longues et les couvre-joints entourent quatre côtés d'une rainure pour entourer la rainure..

2. Dispositif électronique selon la revendication 1, dans lequel une partie inférieure de la surface extérieure est formée avec une partie concave, la partie concave présente une épaisseur de boîtier plus épaisse, et la partie concave est située immédiatement au-dessus d'un module de communication ou d'un processeur de la carte de circuit imprimé.

3. Dispositif électronique selon la revendication 1, comprenant par ailleurs:
une unité de composants (14) disposée sur la carte de circuit imprimé, dans lequel un espace (G2) entre l'unité de composants et le boîtier de dissipateur de chaleur est inférieur à 0,5 mm; et
un élément conducteur de chaleur (15) rempli dans l'espace, où l'épaisseur de l'élément conducteur de chaleur dans l'espace est inférieure à 0,5 mm.

4. Dispositif électronique selon la revendication 1, dans lequel l'espace entre la carte de circuit imprimé et la plate-forme en saillie est inférieur à 2 mm, et une épaisseur de l'élément conducteur de chaleur dans l'espace est inférieure à 0,2 mm.

5. Dispositif électronique selon la revendication 3 ou 4, dans lequel l'élément conducteur de chaleur est une pâte conductrice de chaleur, un tampon conducteur de chaleur ou un mastic conducteur de chaleur.

6. Dispositif électronique selon la revendication 1, comprenant par ailleurs:
un agent conducteur de chaleur (17) disposé sur la carte de circuit imprimé et en contact avec le boîtier de dissipateur de chaleur ou avec le couvercle de fond.
